# EUROPEAN PATENT APPLICATION

(11) **EP 3 460 946 A1**
(43) Date of publication of application: **27.03.2019**
(21) Application number: 16902301.7
(22) Date of filing: 16.05.2016
(51) Int. Cl.: H02J 7/00, H01M 10/44

(54) **BATTERY CONTROL DEVICE, FAULT DETECTION METHOD, AND PROGRAM**

(71) Applicant: Kabushiki Kaisha Toshiba, Minato-ku Tokyo 105-8001 (JP); Toshiba Infrastructure Systems & Solutions Corporation, Kawasaki-shi, Kanagawa 212-8585 (JP)
(72) Inventor: GYODA Minoru, Tokyo 105-8001 (JP); TERASAKI Masanori, Tokyo 105-8001 (JP); MATSUOKA Makoto, Tokyo 105-8001 (JP)
(74) Representative: AWA Sweden AB
(86) International application number: PCT/JP2016/064448
(87) International publication number: WO 2017/199281

(57) **Abstract**

A battery control device of embodiments includes at least two transistors and a control unit. The at least two transistors are at least two transistors that are connected to a battery in series and control charging of the battery, include body diodes, respectively, and are connected in series such that respective body diodes are arranged in the same direction. The control unit changes a conduction pattern in which a conduction state and a non-conduction state of the at least two transistors are switched, and determines whether at least one of the at least two transistors has an abnormality on the basis of a change in a measured voltage.

## Description

### [Technical Field]

Embodiments of the present invention relate to a battery control device, an abnormality detection method, and a program.

### [Background Art]

In recent years, a battery control device (for example, a battery management system (BMS)) which monitors and controls a secondary battery may include a charging cutoff function for preventing overcharging of a secondary battery. In order to realize such a charging cutoff function, a method of using a metal oxide semiconductor field effect transistor (MOS-FET) is known. However, in a conventional battery control device, a failure of the MOS-FET for realizing a charging cutoff function may not be detected accurately in some cases.

### [Citation List]

### [Patent Literature]

[Patent Literature 1]
   Japanese Unexamined Patent Application, First Publication No. 2011-78147
[Patent Literature 2]
   Japanese Unexamined Patent Application, First Publication No. 2013-143077
[Patent Literature 3]
   Japanese Unexamined Patent Application, First Publication No. 2004-333186

### [Summary of Invention]

### [Technical Problem]

An object of the present invention is to provide a battery control device, an abnormality detection method, and a program which can accurately detect an abnormality of a charging cutoff function.

### [Solution to Problem]

A battery control device of an embodiment includes at least two transistors and a control unit. The at least two transistors are connected to a battery in series and control charging of the battery, include body diodes, respectively, and are connected in series such that respective body diodes are arranged in the same direction. The control unit changes a conduction pattern in which a conduction state and a non-conduction state of the at least two transistors are switched and determines whether at least one of the at least two transistors has an abnormality on the basis of a change in a measured voltage.

### [Brief Description of Drawings]

FIG. 1 is a block diagram which shows an example of a battery unit including a battery control device according to an embodiment.
FIG. 2 is a diagram which shows an example of switch switching for voltage measurement of the embodiment.
FIG. 3 is a diagram which shows an example of a conduction pattern and a measurement voltage of a charging FET during a non-charging period.
FIG. 4 is a diagram which shows an example of a conduction pattern and a measurement voltage of the charging FET during a charging period.
FIG. 5 is a flowchart which shows an example of an operation of the battery control device according to the embodiment.
FIG. 6 is a flowchart which shows another example of the operation of the battery control device according to the embodiment.

### [Description of Embodiments]

Hereinafter, a battery control device, an abnormality detection method, and a program according to an embodiment will be described with reference to drawings.

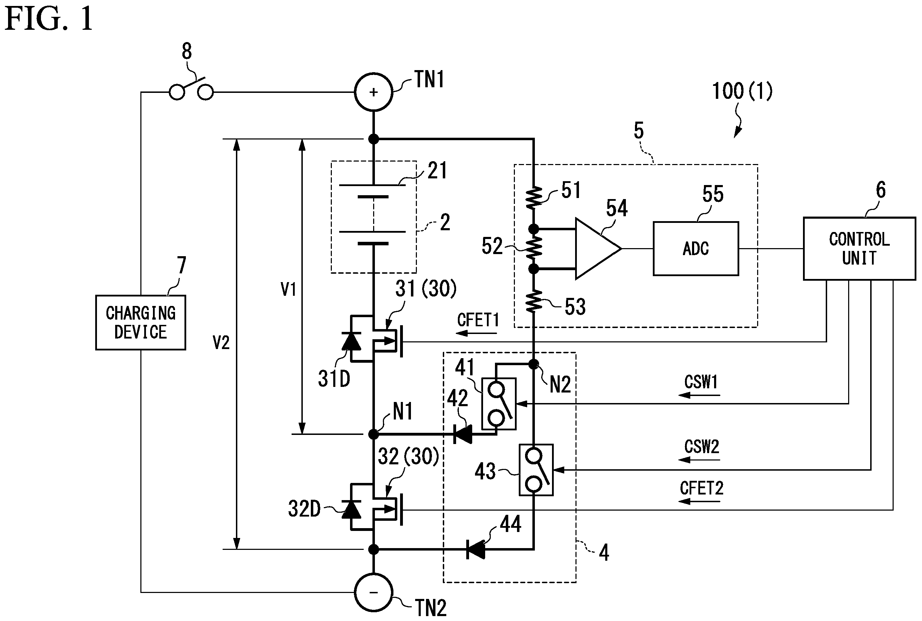

FIG. 1 is a block diagram which shows an example of a battery unit 100 including a battery control device 1 according to the present embodiment.

As shown in FIG. 1, the battery unit 100 includes a battery module 2, charging FETs 31 and 32, a measurement switching unit 4, a voltage measurement unit 5, and a control unit 6. In addition, the battery module 2 is excluded among these components, which is an example of a battery control device 1.

The battery unit 100 of the present embodiment is connected to a load not shown (a battery-using device) which operates using power of the battery module 2.

In addition, in the battery unit 100, when charging the battery module 2, a charging switch 8 is in a conduction state, and thereby the battery module 2 is connected to a charging device 7. As a result, the battery module 2 is charged with power supplied from the charging device 7.

The battery module 2 (an example of a battery) includes a plurality of battery cells 21. The battery cells 21 are, for example, secondary batteries such as lithium-ion batteries or lead-acid batteries. In the battery module 2, the plurality of battery cells 21 are connected in series or/and in parallel. In the battery module 2 of the present embodiment, a negative electrode terminal is described as a first terminal and a positive electrode terminal is described as a second terminal

A positive electrode terminal TN1 is connected to a high potential side of the battery module 2. In addition, a negative electrode terminal TN2 is connected to a low potential side of the battery module 2 via the charging FETs 31 and 32 to be described below.

In the present embodiment, since the charging FET 31 and the charging FET 32 have the same configuration, they will be described as a charging FET 30 if there is no particular distinction.

The charging FET 30 is connected to the battery module 2 in series, and controls charging of the battery module 2. The charging FET 30 includes, for example, a body diode (a parasitic diode). The charging FET 30 is, for example, an N channel MOS-FET. The charging FET 30 is controlled by the control unit 6 to be described below such that it is in an ON state (a conduction state) or an OFF state (a non-conduction state). For example, the charging FET 30 is controlled to be in the ON state by the control unit 6 when the battery module 2 is normally charged, and the charging FET 30 is controlled to be in the OFF state by the control unit 6 when an abnormality such as overcharging is detected.

In the charging FET 31 (an example of a first transistor), a drain terminal is connected to the negative electrode terminal of the battery module 2 (the first terminal), a source terminal is connected to a node N1, and a gate terminal is connected to a signal line of a control signal CFET1. The charging FET 31 is in the ON state (the conduction state) when the control signal CFET1 is in a high state, and is in the OFF state (the non-conduction state) when the control signal CFET1 is in a low state. In addition, the charging FET 31 includes a body diode 31D which is a parasitic diode.

The body diode 31D is a parasitic diode which is formed in a forward direction toward the drain terminal of the charging FET 31 from the source terminal thereof.

The charging FET 32 (an example of a second transistor) is connected to the charging FET 31 in series. The charging FET 32 has a drain terminal connected to the node N1 of the charging FET 31, a source terminal connected to the negative electrode terminal TN2, and a gate terminal connected to a signal line of a control signal CFET2. The charging FET 32 is in the ON state when the control signal CFET2 is in the high state, and is in the OFF state when the control signal CFET1 is in the low state. In addition, the charging FET 32 includes a body diode 32D which is a parasitic diode.

The body diode 32D is a parasitic diode which is formed in a forward direction toward the drain terminal of the charging FET 32 from the source terminal thereof.

The charging FET 31 and the charging FET 32 are connected in series such that the body diodes 31D and 32D are arranged in the same direction. In addition, in the present embodiment, it is assumed and described that the body diode 31D and the body diode 32D have the same forward voltage Vf.

The measurement switching unit 4 switches a voltage measurement circuit for determining an abnormality (a failure) of the charging FET 31 and the charging FET 32. The measurement switching unit 4 switches between a circuit (a first measurement circuit) which measures a voltage V1 between the positive electrode terminal (the first terminal) of the battery module 2 and the source terminal (the node N1) of the charging FET 31 and a circuit (a second measurement circuit) which measures a voltage V2 between the positive electrode terminal of the battery module 2 and the source terminal (the negative electrode terminal TN2) of the charging FET 32. In addition, the measurement switching unit 4 includes switches 41 and 43, and diodes 42 and 44.

A switch 41 (an example of the first switch) connects the source terminal (the node N1) of the charging FET 31 and a node N2 of the voltage measurement unit 5 to measure the voltage V1 described above on the basis of a control signal CSW1 output from the control unit 6. The switch 41 is in the ON state when the control signal CSW1 is in the high state, and is in the OFF state when the control signal CSW1 is in the low state.

An anode terminal of a diode 42 is connected to one end of the switch 41, and a cathode terminal thereof is connected to the node N1. The diode 42 prevents a current from flowing backward when an abnormality of the charging FET 30 is detected.

A switch 43 (an example of a second switch) connects the source terminal (the negative electrode terminal TN2) of the charging FET 32 and the node N2 of the voltage measurement unit 5 to measure the voltage V2 described above on the basis of a control signal CSW2 output from the control unit 6. The switch 43 is, for example, in the ON state when the control signal CSW2 is in the high state, and is in the OFF state when the control signal CSW2 is in the low state.

An anode terminal of a diode 44 is connected to one end of the switch 43, and a cathode terminal thereof is connected to the negative electrode terminal TN2. The diode 44 prevents a current from flowing backward when an abnormality of the charging FET 30 is detected.

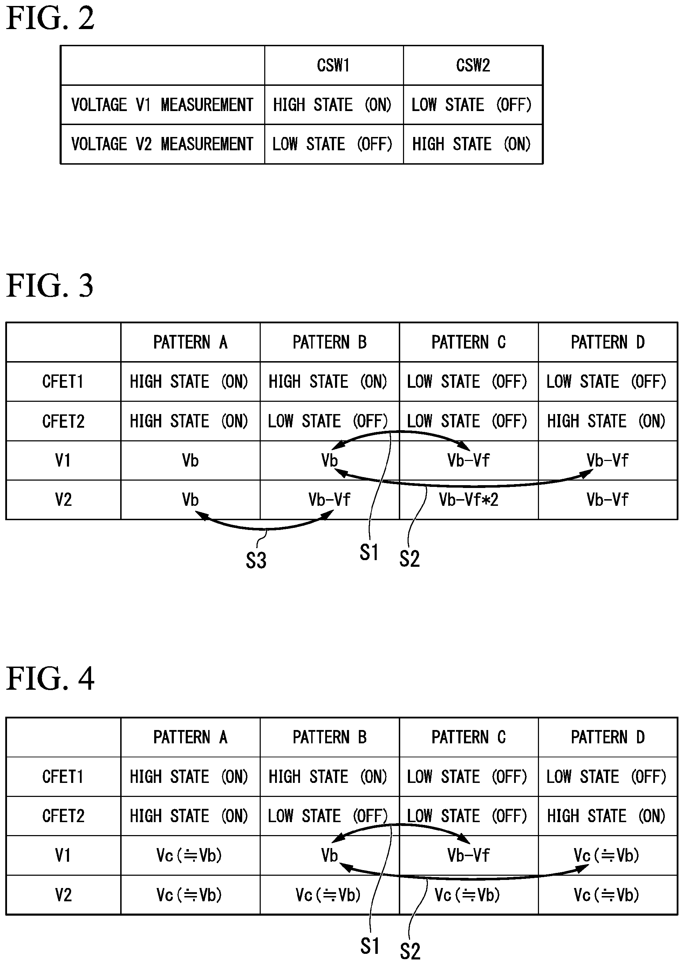

Here, setting of the switch 41 and the switch 43 when the voltage V1 and the voltage V2 are measured will be described with reference to FIG. 2.

FIG. 2 is a diagram which shows an example of switch switching for voltage measurement of the embodiment.

In a table shown in FIG. 2, states of the control signal CSW1 and the control signal CSW2 with respect to the measurement voltage V1 and the measurement voltage V2 are shown. For example, when the measurement voltage V1 is measured, it is shown that there is a need to set the control signal CSW1 to the high state, and to set the control signal CSW2 to the low state. In this case, the switch 41 is in the ON state by the control signal CSW1 being in the high state, and the switch 43 is in the OFF state by the control signal CSW2 being in the low state.

In addition, for example, when the measurement voltage V2 is measured, it is shown that there is a need to set the control signal CSW1 to the low state and to set the control signal CSW2 to the high state. In this case, the switch 41 is in the OFF state by the control signal CSW1 being in the low state, and the switch 43 is the ON state by the control signal CSW2 being in the high state.

Returning to FIG. 1, the voltage measurement unit 5 is a measurement circuit which measures the voltage V1 and the voltage V2. The voltage measurement unit 5 includes, for example, resistors 51, 52, and 53, an amplifier 54, and an analog to digital converter (ADC) 55.

The resistors 51, 52, and 53 are voltage dividing resistors which convert the voltage V1 and the voltage V2 into a predetermined voltage level which can be input to the amplifier 54. The resistor 51 is connected between the positive electrode terminal of the battery module 2 and a first input terminal of the amplifier 54. In addition, the resistor 52 is connected between the first input terminal and a second input terminal of the amplifier 54. The resistor 53 is connected between the second input terminal and a node N2 of the amplifier 54.

The amplifier 54 amplifies a voltage at both ends of the resistor 52 corresponding to the voltage V1 or the voltage V2 with a predetermined amplification factor and outputs it to an ADC 55. For example, when the measurement switching unit 4 is switched to a setting to measure the voltage V1, the amplifier 54 outputs a voltage corresponding to the voltage V1 to the ADC 55. In addition, for example, when the measurement switching unit 4 is switched to a setting to measure the voltage V2, the amplifier 54 outputs a voltage corresponding to the voltage V2 to the ADC 55.

The ADC 55 converts a voltage (an analog value) corresponding to the voltage V1 or the voltage V2 output by the amplifier 54 into a digital value, and outputs a digital value of the voltage corresponding to the voltage V1 or the voltage V2 to the control unit 6.

The control unit 6 is, for example, a processor including a central processing unit (CPU), and the like, and integrally controls the battery control device 1. The control unit 6 controls charging of the battery module 2 by, for example, controlling the charging FET 30. In addition, the control unit 6 determines whether at least one charging FET 30 among the charging FETs 30 (31 and 32) has an abnormality on the basis of a change in voltage measured by, for example, sequentially changing and switching a pattern of the ON state and the OFF state of the charging FETs 30 (31 and 32).

The control unit 6 controls, for example, the control signal CSW1 and the control signal CSW2 as shown in FIG. 2, and performs control to cause the voltage measurement unit 5 to measure the voltage V1 and the voltage V2. In addition, the control unit 6 sequentially switches a pattern of the control signal CFET1 and the control signal CFET2, sequentially switches the pattern of the ON state and the OFF state of the charging FETs 30 (31 and 32), and acquires the voltage V1 and the voltage V2 measured by the voltage measurement unit 5 described above. The control unit 6 determines whether the charging FET 30 (31 or 32) has an abnormality on the basis of a change in the acquired voltages V1 and V2.

FIG. 3 is a diagram which shows an example of a conduction pattern and a measurement voltage of the charging FET 30 during a non-charging period.

In the example shown in FIG. 3, the charging device 7 is not connected to either the positive electrode terminal TN1 or the negative electrode terminal TN2. In addition, when the charging FET 31 and the charging FET 32 are normal, expected values of the voltage V1 and the voltage V2 measured by changing a pattern in which the ON state and the OFF state of the charging FET 30 are switched (hereinafter, referred to as a conduction pattern) are shown in FIG. 3.

In FIG. 3, a "pattern A" indicates a conduction pattern in which the control signal CFET1 is in the high state, the control signal CFET2 is in the high state, and both the charging FET 31 and the charging FET 32 are in the ON state. An expected value of a voltage V1 in the "pattern A" shown in FIG. 3 is a voltage Vb which is an output voltage (a charging voltage) of the battery module 2. In addition, an expected value of a voltage V2 in the "pattern A" shown in FIG. 3 is the voltage Vb like that of the voltage V1.

Moreover, the control signal CFET1 is in the high state and the control signal CFET2 is in the low state in a "pattern B." That is the "pattern B" indicates a conduction pattern in which the charging FET 31 is in the ON state and the charging FET 32 is in the OFF state. An expected value of a voltage V1 in the "pattern B" shown in FIG. 3 is the voltage Vb. In addition, an expected value of a voltage V2 in the "pattern B" shown in FIG. 3 is a voltage (Vb-Vf).

That is, since the charging FET 32 is in the OFF state in the "pattern B," when the voltage V2 is measured, a current flows to the node N1 from the negative electrode terminal TN2 via the body diode 32D. For this reason, a potential of the negative electrode terminal TN2 becomes a potential higher than a potential of the node N1 by the forward voltage Vf of the body diode 32D. In addition, since the charging FET 31 is in the ON state, the node N1 and the negative electrode terminal of the battery module 2 have the same potential. Based on these points, the voltage V2 in the "pattern B" is the voltage (Vb-Vf).

In addition, the control signal CFET1 is in the low state and the control signal CFET2 is in the low state in a "pattern C." That is, the "pattern C" indicates a conduction pattern in which both the charging FET 31 and the charging FET 32 are in the OFF state. An expected value of a voltage V1 in the "pattern C" shown in FIG. 3 is the voltage (Vb-Vf). In addition, an expected value of a voltage V2 in the "pattern C" shown in FIG. 3 is a voltage (Vb-Vf×2).

That is, since the charging FET 31 is in the OFF state in the "pattern C," when the voltage V1 is measured, a current flows to the negative electrode terminal of the battery module 2 from the node N1 via the body diode 31D. For this reason, the potential of the node N1 becomes a potential higher than the potential of the negative electrode terminal of the battery module 2 by the forward voltage Vf of the body diode 31D. Based on this point, the voltage V1 in the "pattern C" is the voltage (Vb-Vf).

Furthermore, since the charging FET 32 is in the OFF state, when the voltage V2 is measured, a current flows to the negative electrode terminal of the battery module 2 from the negative electrode terminal TN2 via the body diode 32D and the body diode 31D. For this reason, the potential of the negative electrode terminal TN2 becomes a potential higher than the potential of the negative electrode terminal of the battery module 2 by the forward voltage Vf of the body diode 31D and the forward voltage Vf of the body diode 32D. Based on this point, the voltage V2 in the "pattern C" is a voltage (Vb-Vf×2).

In addition, the control signal CFET1 is in the low state and the control signal CFET2 is in the high state in a "pattern D." That is, the "pattern D" indicates a conduction pattern in which the charging FET 31 is in the OFF state and the charging FET 32 is in the ON state. An expected value of a voltage V1 in the "pattern D" shown in FIG. 3 is the voltage (Vb-Vf). In addition, an expected value of a voltage V2 in the "pattern D" shown in FIG. 3 is a voltage (Vb-Vf) like that of the voltage V1.

That is, since the charging FET 31 is in the OFF state in the "pattern D," when the voltage V1 is measured, a current flows to the negative electrode terminal of the battery module 2 from the node N1 via the body diode 31D. For this reason, the potential of the node N1 becomes a potential higher than the potential of the negative electrode terminal of the battery module 2 by the forward voltage Vf of the body diode 31D. Based on this point, the voltage V1 in the "pattern D" is the voltage (Vb-Vf).

In addition, since the charging FET 32 is in the ON state, the node N1 and the negative electrode terminal TN2 have the same potential. For this reason, the voltage V2 in the "pattern D" is the voltage (Vb-Vf) which is a voltage equal to the voltage V1.

In addition, FIG. 4 is a diagram which shows an example of a conduction pattern and a measurement voltage of the charging FET 30 during a charging period.

In the example shown in FIG. 4, the charging device 7 is connected to both the positive electrode terminal TN1 and the negative electrode terminal TN2 via the charging switch 8. In addition, when the charging FET 31 and the charging FET 32 are normal, expected values of the voltage V1 and the voltage V2 measured by changing a conduction pattern of the charging FET 30 are shown in FIG. 4.

In the example shown in FIG. 4, the charging device 7 may perform float charging for supplying a voltage Vc which is a charging voltage substantially equal to the voltage Vb of the battery module 2 in some cases.

Both the expected value of the voltage V1 and the expected value of the voltage V2 in the "pattern A" shown in FIG. 4 are the voltage Vc (≈Vb).

In addition, the expected value of the voltage V1 in the "pattern B" shown in FIG. 4 is the voltage Vb, and the expected value of the voltage V2 is the voltage Vc (≈Vb). In this case, even if the charging FET 32 is in the OFF state, since the voltage Vc supplied as the charging voltage is substantially equal to the voltage Vb of the battery module 2, a current does not flow in the body diode 32D. For this reason, the voltage V2 in the "pattern B" is the voltage Vc (≈Vb).

In addition, the expected value of the voltage V1 in the "pattern C" shown in FIG. 4 is the voltage (Vb-Vf), and the expected value of the voltage V2 is the voltage Vc (≈Vb) like in the "pattern B."

Moreover, both the expected value of the voltage V1 and the expected value of the voltage V2 in the "pattern D" shown in FIG. 4 are the voltage Vc (≈Vb). In this case, since the charging FET 32 is in the ON state, the node N1 and the negative electrode terminal TN2 have the same potential. For this reason, the voltage V1 in the "pattern D" is the voltage Vc (≈Vb) which is a voltage equal to the voltage V2.

Returning to FIG. 1 again, the control unit 6 acquires the voltage V1 and the voltage V2 measured by the voltage measurement unit 5 by changing the control signal CFET1, the control signal CFET2, the control signal CSW1, and the control signal CSW2, and sequentially changing the "pattern A" to the "pattern D" described above. The control unit 6 determines an abnormality of the charging FET 31 on the basis of a change in the voltage V1 measured by changing a conduction pattern described above, and determines the abnormality of the charging FET 31 on the basis of a change in the voltage V2.

The control unit 6 determines whether there is an abnormality in the charging FET 31 on the basis of, for example, a change in the voltage V1 of the "pattern B" (hereinafter, referred to as a voltage V1_{B}) and the voltage V1 of the "pattern C" (hereinafter, referred to as a voltage V1_{C}) as first determination processing S1. The control unit 6 determines that the charging FET 31 has an abnormality when the change in the voltage V1 (the change in the voltage V1_{B} and the voltage V1_{C}) is outside a predetermined range based on a forward voltage Vf of the charging FET 31.

That is, the control unit 6 determines that the charging FET 31 is normal when a voltage of a difference between the voltage V1_{B}(=Vb) and the voltage V1_{C}(=Vb-Vf) is within a range from a voltage (Vf-a) to a voltage (Vf+α). In addition, the control unit 6 determines that the charging FET 31 has an abnormality when the voltage of the difference between the voltage V1_{B} (=Vb) and the voltage V1_{C} (=Vb-Vf) is outside the range from a voltage (Vf-a) to a voltage (Vf+α). Here, α is a predetermined value in consideration of possible variations of the forward voltage Vf.

In this manner, the control unit 6 determines that the charging FET 31 has an abnormality when the change in the voltage V1 is outside a predetermined range based on the forward voltage Vf of the charging FET 31.

In addition, the control unit 6, as second determination processing S2, determines whether the battery module 2 is charging, for example, on the basis of a change in the voltage V1_{B} of the "pattern B" and the voltage V1 (hereinafter, referred to as a voltage V1_{D}). The control unit 6 determines that the battery module 2 is not charging when the voltage V1_{D} is the voltage (Vb-Vf), for example, as shown in FIG. 3. That is, the control unit 6 determines that the battery module 2 is not charging when a voltage difference between the voltage V1_{B} (=Vb) and the voltage V1_{D} (=Vb-Vf) is within a range from a voltage (Vf-a) to a voltage (Vf+α). In addition, the control unit 6 determines that the battery module 2 is charging when the voltage difference between the voltage V1_{B} (=Vb) and the voltage V1_{D} (=Vb-Vf) is out of the range from a voltage (Vf-a) to a voltage (Vf+α). The control unit 6 determines, for example, that the battery module 2 is float charging when the voltage V1_{D} is the voltage Vc (≈Vb) as shown in FIG. 4.

In this manner, the control unit 6 determines whether the battery module 2 is charging on the basis of a change in the voltage V1 when it is determined that the charging FET 31 is normal on the basis of the change in the voltage V1. Furthermore, the control unit 6 determines a float charging state on the basis of a change in the voltage V1_{B} measured, on the basis of a change in the voltage V1, in a conduction pattern (the "pattern B") in which the charging FET 31 is in the ON state and the charging FET 32 is in the OFF state and the voltage V1_{D} measured in a conduction pattern (the "pattern D") in which the charging FET 31 is in the OFF state and the charging FET 32 is in the ON state.

Moreover, the control unit 6 determines the abnormality of the charging FET 32 on the basis of a change in the voltage V2 when it is determined that the battery module 2 is not charging. The control unit 6, as third determination processing S3, determines whether the charging FET 32 has an abnormality, for example, on the basis of a change in the voltage V2 of the "pattern A" (hereinafter, referred to as a voltage V2_{A}) and a voltage V2 of the "pattern B" (hereinafter, referred to as a voltage V2_{B}). The control unit 6 determines that the charging FET 32 has an abnormality when the change in the voltage V2 (the change in the voltage V2_{A} and the voltage V2_{B}) is out of a predetermined range based on a forward voltage Vf of the charging FET 32.

That is, the control unit 6 determines that the charging FET 32 is normal when the voltage difference between the voltage V2_{A} (=Vb) and the voltage V2_{B} (=Vb-Vf) is within the range from a voltage (Vf-a) to a voltage (Vf+α). In addition, the control unit 6 determines that the charging FET 32 has an abnormality when the voltage difference between the voltage V2_{A} (=Vb) and the voltage V2_{B} (=Vb-Vf) is out of the range from a voltage (Vf-a) to a voltage (Vf+α).

Next, an operation of the battery control device 1 according to the present embodiment will be described with reference to drawings.

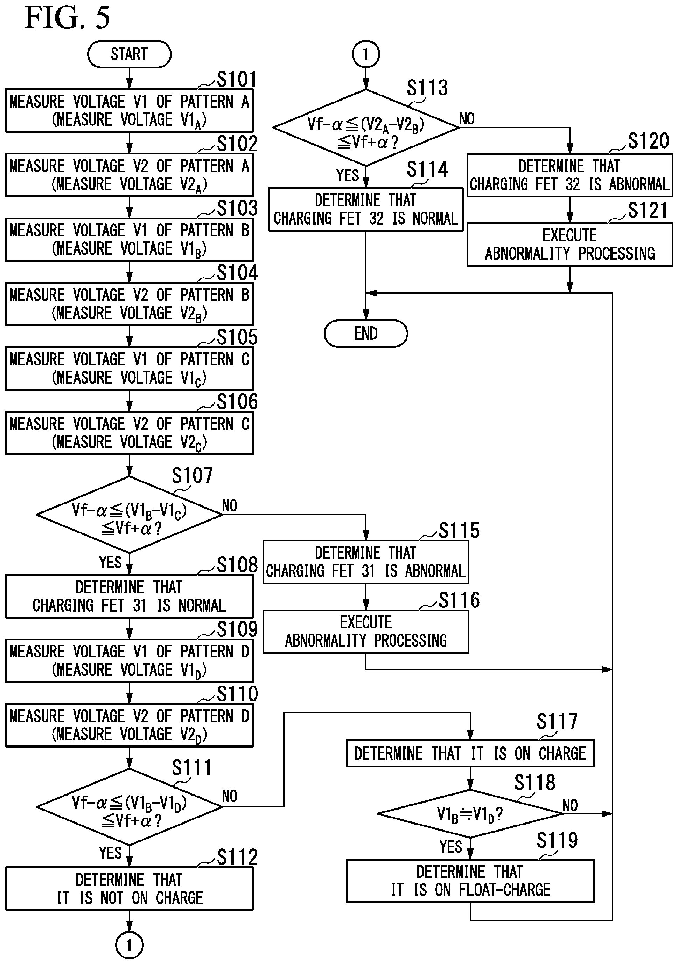

FIG. 5 is a flowchart which shows an example of the operation of the battery control device 1 according to the present embodiment.

The battery control device 1 executes processing of determining an abnormality of the charging FET 30 shown in FIG. 5, for example, when a power consumption mode is shifted to a low power consumption mode, or periodically.

In FIG. 5, first, the control unit 6 of the battery control device 1 measures the voltage V1 of the "pattern A" (hereinafter, referred to as a voltage V1_{A}) (step S101). The control unit 6 sets the CFET1 and CEFT2 to the high state, and sets the charging FET 31 and the charging FET 32 to the ON state. In addition, the control unit 6 sets CSW1 to the high state to set the switch 41 to the ON state, and sets the CSW2 to the low state to set the switch 43 to the OFF state. Then, the control unit 6 acquires the voltage V1_{A} measured by the voltage measurement unit 5.

Next, the control unit 6 measures the voltage V2 of the "pattern A" (the voltage V2_{A}) (step S102). The control unit 6 sets CSW1 to the low state to set the switch 41 to the OFF state, and sets CSW2 to the high state to set the switch 43 to the ON state. Then, the control unit 6 acquires the voltage V2_{A} measured by the voltage measurement unit 5.

Next, the control unit 6 measures the voltage V1 of the "pattern B" (the voltage V1_{B}) (step S103). The control unit 6 sets CFET1 to the high state to set the charging FET 31 to the ON state, and sets CFET2 to the low state to set the charging FET 32 to the OFF state. In addition, the control unit 6 sets CSW1 to the high state to set the switch 41 to the ON state, and sets CSW2 to the low state to set the switch 43 to the OFF state. Then, the control unit 6 acquires the voltage V1_{B} measured by the voltage measurement unit 5.

Next, the control unit 6 measures the voltage V2 of the "pattern B" (the voltage V2_{B}) (step S104). The control unit 6 sets CSW1 to the low state to set the switch 41 to the OFF state, and sets CSW2 to the high state to set the switch 43 to the ON state. Then, the control unit 6 acquires the voltage V2_{B} measured by the voltage measurement unit 5.

Next, the control unit 6 measures the voltage V1 of the "pattern C" (the voltage V1_{C}) (step S105). The control unit 6 sets CFET1 to the low state to set the charging FET 31 to the OFF state, and sets the CFET2 to the low state to set the charging FET 32 to the OFF state. In addition, the control unit 6 sets CSW1 to the high state to set the switch 41 to the ON state, and sets CSW2 to the low state to set the switch 43 to the OFF state. Then, the control unit 6 acquires the voltage V1_{C} measured by the voltage measurement unit 5.

Next, the control unit 6 measures a voltage V2 of the "pattern C" (hereinafter, referred to as a voltage V2c) (step S106). The control unit 6 sets CSW1 to the low state to set the switch 41 to the OFF state, and sets CSW2 to the high state to set the switch 43 to the ON state. Then, the control unit 6 acquires the voltage V2c measured by the voltage measurement unit 5.

Next, the control unit 6 determines whether a difference between the voltage V1_{B} of the "pattern B" and the voltage V1_{C} of the "pattern C" is within the range of (Vf±α) (Vf-α≤(V1_{B}-V1_{C})≤Vf+α) (step S107). The control unit 6 proceeds with the processing to step S108 when the difference between the voltage V1_{B} of the "pattern B" and the voltage V1_{C} of the "pattern C" is within the range of (Vf±α) (Vf-α≤(V1_{B}-V1_{C})≤Vf+α) (YES in step S107). In addition, the control unit 6 proceeds with the processing to step S115 when the difference between the voltage V1_{B} of the "pattern B" and the voltage V1_{C} of the "pattern C" is out of the range of (Vf±α) (Vf-α>(V1_{B}-V1_{C}) or (V1_{B}-V1_{C})>Vf+α) (NO in step S107).

In step S108, the control unit 6 determines that the charging FET 31 is normal.

Next, the control unit 6 measures a voltage V1 of the "pattern D" (the voltage V1_{D}) (step S109). The control unit 6 sets CFET1 to the low state to set the charging FET 31 to the OFF state, and sets CFET2 to the high state to set the charging FET 32 to the ON state. In addition, the control unit 6 sets CSW1 to the high state to set the switch 41 to the ON state, and sets CSW2 to the low state to set the switch 43 to the OFF state. Then, the control unit 6 acquires the voltage V1_{D} measured by the voltage measurement unit 5.

Next, the control unit 6 measures a voltage V2 of the "pattern D" (hereinafter, referred to as a voltage V2_{D}) (step S110). The control unit 6 sets CSW1 to the low state to set the switch 41 to the OFF state, and sets CSW2 to the high state to set the switch 43 to the ON state. Then, the control unit 6 acquires the voltage V2_{D} measured by the voltage measurement unit 5.

Next, the control unit 6 determines whether a difference between the voltage V1_{B} of the "pattern B" and the voltage V1_{D} of the "pattern D" is within the range of (Vf±α) (Vf-α≤(V1_{B}-V1_{D})≤Vf+α) (step S111). The control unit 6 proceeds with the processing to step S112 when the difference between the voltage V1_{B} of the "pattern B" and the voltage V1_{D} of the "pattern D" is within the range of (Vf±α) (Vf-α≤(V1_{B}-V1_{D})≤Vf+α) (YES in step S111). In addition, the control unit 6 proceeds with the processing to step S117 when the difference between the voltage V1_{B} of the "pattern B" and the voltage V1_{D} of the "pattern D" is out of the range of (Vf±α) (Vf-α>(V1_{B}-V1_{D}) or (V1_{B}-V1_{D})>Vf+α) (NO in step S111).

In step S112, the control unit 6 determines that the battery module 2 is not charging.

Next, the control unit 6 determines whether a difference between the voltage V2_{A} of the "pattern A" and the voltage V2_{B} of the "pattern B" is within the range of (Vf±α) (Vf-α≤(V2_{A}-V2_{B})≤Vf+α) (step S113). The control unit 6 proceeds with the processing to step S114 when the difference between the voltage V2_{A} of the "pattern A" and the voltage V2_{B} of the "pattern B" is within the range of (Vf±α) (Vf-α≤(V2_{A}-V2_{B})<Vf+α) (YES in step S113). In addition, the control unit 6 proceeds with the processing to step S120 when the difference between the voltage V2_{A} of the "pattern A" and the voltage V2_{B} of the "pattern B" is out of the range of (Vf±α) (Vf-α>(V2_{A}-V2_{B}) or (V2_{A}-V2_{B})>Vf+α) (NO in step S113).

In step S114, the control unit 6 determines that the charging FET 32 is normal. After the processing of step S114, the control unit 6 ends the processing.

In step S115, the control unit 6 determines that the charging FET 31 has an abnormality. Then, the control unit 6 executes abnormality processing (step S116). For example, the control unit 6 transmits a warning indicating that the charging FET 31 (the charging FET 30) has an abnormality to a battery-using device. After the processing of step S116, the control unit 6 ends the processing.

In step S117, the control unit 6 determines that the battery module 2 is charging.

Next, the control unit 6 determines whether the voltage V1_{B} of the "pattern B" is substantially equal to the voltage V1_{D} of the "pattern D" (V1_{B}≈V1_{D}) (step S118). For example, the control unit 6 determines whether the voltage V1_{B} is substantially equal to the voltage V1_{D} depending on whether a difference between the voltage V1_{B} and the voltage V1_{D} is equal to or less than a predetermined value β. The control unit 6 proceeds with the processing to step S119 when the voltage V1_{B} is substantially equal to the voltage V1_{D} (V1_{B}≈V1_{D}) (YES in step S118). In addition, the control unit 6 ends the processing when the voltage V1_{B} is not substantially equal to the voltage V1_{D} (V1_{B}≠V1_{D}) (NO in step S118).

In step S119, the control unit 6 determines that the battery module 2 is float charging. After the processing of step S119, the control unit 6 ends the processing.

In step S120, the control unit 6 determines that the charging FET 32 has an abnormality. Then, the control unit 6 executes the abnormality processing (step S121). The control unit 6, for example, transmits a warning indicating that the charging FET 32 (the charging FET 30) has an abnormality to a battery-using device. After the processing of step S1121, the control unit 6 ends the processing.

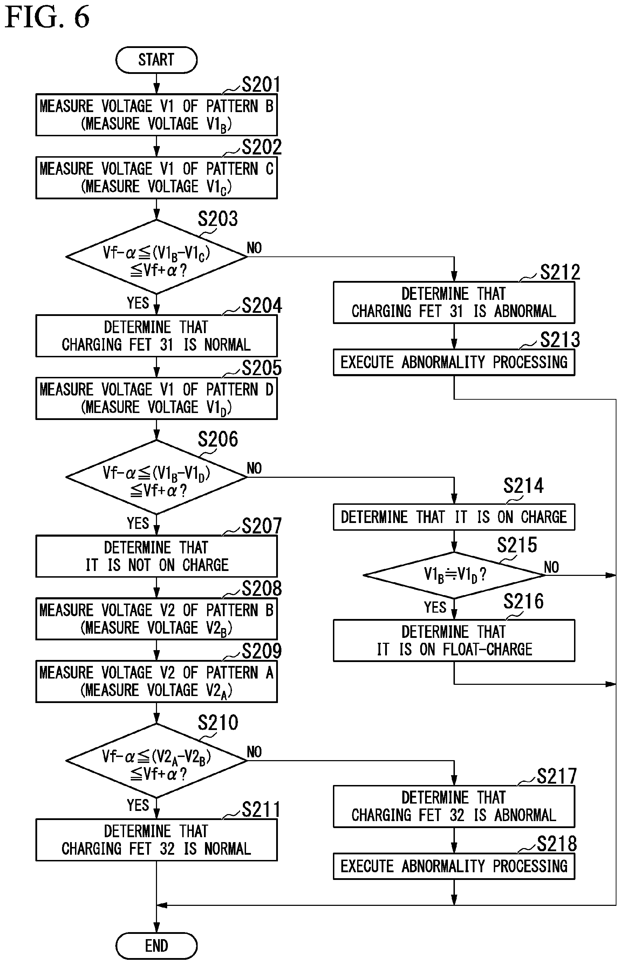

In the example shown in FIG. 5 described above, an example in which the voltages V1 and V2 are continuously measured after the battery control device 1 changes a conduction pattern has been described, but the voltage V2 with a changed conduction pattern may be measured after the voltage V1 with the changed conduction pattern is measured. In addition, an order of changing a conduction pattern is not limited to that in FIG. 5 described above. Therefore, next, a modified example of the operation of the battery control device 1 according to the present embodiment will be described with reference to FIG. 6.

FIG. 6 is a flowchart which shows another example of the operation of the battery control device 1 according to the present embodiment.

The battery control device 1, like the example shown in FIG. 5, executes processing of determining an abnormality of the charging FET 30 shown in FIG. 6, for example, when the power consumption mode is shifted to the low power consumption mode, or periodically.

In FIG. 6, first, the control unit 6 measures the voltage V1 of the "pattern B" (the voltage V1_{B}) (step S201). The control unit 6 sets CFET1 to the high state to set the charging FET 31 to the ON state, and sets CFET2 to the low state to set the charging FET 32 to the OFF state. In addition, the control unit 6 sets CSW1 to the high state to set the switch 41 to the ON state, and sets CSW2 to the low state to set the switch 43 to the OFF state. Then, the control unit 6 acquires the voltage V1_{B} measured by the voltage measurement unit 5.

Next, the control unit 6 measures the voltage V1 of the "pattern C" (the voltage V1_{C}) (step S202). The control unit 6 sets CFET1 and CFET2 to the low state to set the charging FET 31 and the charging FET 32 to the OFF state. Then, the control unit 6 acquires the voltage V1_{C} measured by the voltage measurement unit 5.

Next, the control unit 6 determines whether a difference between the voltage V1_{B} of the "pattern B" and the voltage V1_{C} of the "pattern C" is within the range of (Vf±α) (Vf-α≤(V1_{B}-V1_{C})≤Vf+α) (step S203). The control unit 6 proceeds with the processing to step S204 when the difference between the voltage V1_{B} of the "pattern B" and the voltage V1_{C} of the "pattern C" is within the range of (Vf±α) (Vf-α≤(V1_{B}-V1_{C})≤Vf+α) (YES in step S203). In addition, the control unit 6 proceeds with the processing to step S212 when the difference between the voltage V1_{B} of the "pattern B" and the voltage V1_{C} of the "pattern C" is out of the range of (Vf±α) (Vf-α>(V1_{B}-V1_{C}) or (V1_{B}-V1_{C})>Vf+α) (NO in step S203).

In step S204, the control unit 6 determines that the charging FET 31 is normal.

Next, the control unit 6 measures the voltage V1 of the "pattern D" (the voltage V1_{D}) (step S205). The control unit 6 sets CFET1 to the low state to set the charging FET 31 to the OFF state, and sets CFET2 to the high state to set the charging FET 32 to the ON state. Then, the control unit 6 acquires the voltage V1_{D} measured by the voltage measurement unit 5.

Next, the control unit 6 determines whether a difference between the voltage V1_{B} of the "pattern B" and the voltage V1_{D} of the "pattern D" is within the range of (Vf±α) (Vf-α≤(V1_{B}-V1_{D})≤Vf+α) (step S206). The control unit 6 proceeds with the processing to step S207 when the difference between the voltage V1_{B} of the "pattern B" and the voltage V1_{D} of the "pattern D" is within the range of (Vf±α) (Vf-α≤(V1_{B}-V1_{D})≤Vf+α) (YES in step S206). In addition, the control unit 6 proceeds with the processing to step S214 when the difference between the voltage V1_{B} of the "pattern B" and the voltage V1_{D} of the "pattern D" is out of the range of (Vf±α) (Vf-α>(V1_{B}-V1_{D}) or (V1_{B}-V1_{D})>Vf+α) (NO in step S206).

In step S207, the control unit 6 determines that the battery module 2 is not charging.

Next, the control unit 6 measures the voltage V2 of the "pattern B" (the voltage V2_{B}) (step S208). The control unit 6 sets CFET1 to the high state to set the charging FET 31 to the ON state, and sets CFET2 to the low state to set the charging FET 32 to the OFF state. In addition, the control unit 6 sets CSW1 to the low state to set the switch 41 to the OFF state, and sets CSW2 to the high state to set the switch 43 to the ON state. Then, the control unit 6 acquires the voltage V2_{B} measured by the voltage measurement unit 5.

Next, the control unit 6 measures the voltage V2 of the "pattern A" (the voltage V2_{A}) (step S209). The control unit 6 sets CFET1 and CFET2 to the high state to set the charging FET 31 and the charging FET 32 to the ON state. Then, the control unit 6 acquires the voltage V2_{A} measured by the voltage measurement unit 5.

Next, the control unit 6 determines whether a difference between the voltage V2_{A} of the "pattern A" and the voltage V2_{B} of the "pattern B" is within the range of (Vf±α) (Vf-α≤(V2_{A}-V2_{B})≤Vf+α) (step S210). The control unit 6 proceeds with the processing to step S211 when the difference between the voltage V2_{A} of the "pattern A" and the voltage V2_{B} of the "pattern B" is within the range of (Vf±α) (Vf-α≤(V2_{A}-V2_{B})≤Vf+α) (YES in step S210). In addition, the control unit 6 proceeds with the processing to step S217 when the difference between the voltage V2_{A} of the "pattern A" and the voltage V2_{B} of the "pattern B" is out of the range of (Vf±α) (Vf-α>(V2_{A}-V2_{B}) or (V2_{A}-V2_{B})>Vf+α) (NO in step S210).

In step S211, the control unit 6 determines that the charging FET 32 is normal. After the processing of step S211, the control unit 6 ends the processing.

Since processing of step S212 and step S213 are the same as the processing of step S115 and step S116 of FIG. 5 described above, the description thereof will be omitted herein.

In addition, since processing from step S214 to step S216 are the same as the processing from the step S117 to step S119 of FIG. 5 described above, the description thereof will be omitted herein.

Moreover, since processing from step S217 to step S218 are the same as the processing from the step S120 to step S121 of FIG. 5 described above, the description thereof will be omitted herein.

As described above, the battery control device 1 of the present embodiment includes at least two charging FETs 30 (transistors) and the control unit 6. The at least two charging FETs 30 are at least two charging FETs 30 (for example, the charging FET 31 and the charging FET 32) which are connected to the battery module 2 (a battery) in series, and control charging of the battery module 2, include body diodes (for example, the body diode 31D and the body diode 32D), respectively, and are connected in series such that respective body diodes are arranged in the same direction. The control unit 6 changes a conduction pattern in which the ON state (the conduction state) and the OFF state (the non-conduction state) of at least two charging FETs 30 are switched, and determines whether at least one of the at least two charging FETs 30 has an abnormality on the basis of a change in a measured voltage (for example, the voltage V1 or the voltage V2).

As a result, since the battery control device 1 of the present embodiment can accurately determine an abnormality of the charging FET 30, it is possible to accurately detect an abnormality of a charging cutoff function. In addition, the battery control device 1 of the present embodiment includes at least two charging FETs 30, and thus, even though one of the at least two charging FETs 30 fails, it is possible to appropriately cutoff a charging current at the time of overcharging.

Moreover, in the present embodiment, the control unit 6 determines that the charging FET 31 has an abnormality when the change in the voltage (for example, the voltage V1 or the voltage V2) is out of a predetermined range based on the forward voltage of the charging FET 30.

As a result, the battery control device 1 of the present embodiment uses the forward voltage of the charging FET 30, and thereby it is possible to accurately determine, for example, an abnormality such as a short circuit failure of the charging FET 30 with a simple configuration.

In addition, in the present embodiment, the at least two charging FETs 30 include the charging FET 31 (a first transistor) whose drain terminal is connected to the negative electrode terminal of the battery module 2 (the first terminal), and the charging FET 32 (a second transistor) whose drain terminal is connected to the source terminal of the charging FET 31. The control unit 6 determines the abnormality of the charging FET 31 on the basis of a change in the voltage V1 (a first voltage), and determines an abnormality of the charging FET 32 on the basis of a change in the voltage V2 (a second voltage) measured by changing a conduction pattern. Here, the voltage V1 is a voltage between the positive electrode terminal of the battery module 2 (the second terminal) and the source terminal of the charging FET 31. In addition, the voltage V2 is a voltage between the positive electrode terminal of the battery module 2 and the source terminal of the charging FET 32.

As a result, the battery control device 1 of the present embodiment can accurately determine an abnormality of the charging FET 31 and the charging FET 32 using a simple configuration. In addition, the battery control device 1 of the present embodiment uses the two charging FETs 30 (the charging FET 31 and the charging FET 32) and a change in two measured voltages (the voltage V1 and the voltage V2), and thereby, for example, it is possible to determine whether the battery module 2 is charging. For this reason, the battery control device 1 of the present embodiment can reduce erroneous determination of an abnormality of the charging FET 30 due to the battery module 2 being charged.

Moreover, in the present embodiment, the control unit 6 determines whether the battery module 2 is charging on the basis of a change in the voltage V1. The control unit 6 determines the abnormality of the charging FET 32 on the basis of a change in the voltage V2 when it is determined that the battery module 2 is not charging.

As a result, the battery control device 1 of the present embodiment can reduce erroneous determination of the abnormality of the charging FET 32 due to the battery module 2 being charged. In addition, the battery control device 1 of the present embodiment can accurately determine the abnormality of the charging FET 32.

In addition, in the present embodiment, the control unit 6 determines the abnormality of the charging FET 31 on the basis of a change in a voltage V1 (the voltage V1_{B}) measured in a conduction pattern (the "pattern B") in which the charging FET 31 is in the ON state and the charging FET 32 is in the OFF state, and a voltage V1 (the voltage V1_{C}) measured in a conduction pattern (the "pattern C") in which both the charging FET 31 and the charging FET 32 are in the OFF state.

As a result, the battery control device 1 of the present embodiment can accurately determine the abnormality of the charging FET 32.

In addition, in the present embodiment, the control unit 6 determines the abnormality of the charging FET 32 on the basis of a change in a voltage V2 (the voltage V2_{A}) measured in a conduction pattern (the "pattern A") in which both the charging FET 31 and the charging FET 32 are in the ON state, and a voltage V2 (the voltage V2_{B}) measured in a conduction pattern (the "pattern B") in which the charging FET 31 is in the ON state and the charging FET 32 is in the OFF state.

As a result, the battery control device 1 of the present embodiment can accurately determine the abnormality of the charging FET 32.

In addition, in the present embodiment, the control unit 6 determines a float charging state on the basis of a change in the voltage V1 (the voltage V1_{B}) measured in the conduction pattern (the "pattern B") in which the charging FET 31 is in the ON state and the charging FET 32 is in the OFF state, and a voltage V1 (the voltage V1_{D}) measured in a conduction pattern (the "pattern D") in which the charging FET 31 is in the OFF state and the charging FET 32 is in the ON state when it is determined that the charging FET 31 is normal on the basis of the change in the voltage V1.

As a result, the battery control device 1 of the present embodiment can accurately determine that the battery module 2 is float charging using a simple configuration.

Moreover, in the present embodiment, the control unit 6 changes all conduction patterns (from the "pattern A" to the "pattern D"), and determines an abnormality of at least one of the at least two charging FETs 30 on the basis of a change in a measured voltage.

As a result, the battery control device 1 of the present embodiment can more accurately determine the abnormality of the charging FET 30 by changing all conduction patterns (from the "pattern A" to the "pattern D").

Moreover, an abnormality detection method of the present embodiment is an abnormality detection method which is executed by the battery control device 1 including at least two charging FETs 30 that are at least two transistors connected to the battery module 2 in series and control charging of the battery module 2, include the body diodes (31D and 32D), respectively, and are connected such that respective body diodes are arranged in the same direction, and the method includes a measurement step and a determination step. In the measurement step, the battery control device 1 changes a conduction pattern in which the ON state or the OFF state of the at least two charging FETs 30 are switched and measures a voltage. In the determination step, the battery device 1 determines whether at least one of the at least two charging FETs 30 has an abnormality on the basis of a change in the voltage measured in the measurement step.

As a result, since the abnormality detection method of the present embodiment can accurately determine the abnormality of the charging FET 30 in the same manner as the battery control device 1 described above, it is possible to accurately detect the abnormality of a charging cutoff function.

The determination processing by the control unit 6 is not limited to the processing procedures of FIGS. 5 and 6 described above, and may be other processing procedures. For example, in the processing procedures of FIGS. 5 and 6, an example in which the control unit 6 changes some conduction patterns and executes various types of determination processing on the basis of a change in a measured voltage (the voltage V1 and the voltage V2) has been described, but various types of determination processing may also be executed after changing all conduction patterns and performing measurement.

In addition, a conduction pattern used in various types of determination processing described above is not limited to the above embodiments, and the control unit 6 may execute various types of determination processing on the basis of a change in a voltage due to another conduction pattern.

Moreover, in the embodiments described above, an example in which N channel MOS-FETs are used as the charging FETs 30, and are connected to the negative electrode terminal of the battery module 2 in series has been described, but the present invention is not limited to thereto. For example, P channel MOS-FETs may also be used as the charging FETs 30, and may also be connected to the positive electrode terminal of the battery module 2 in series.

According to at least one embodiment described above, with at least two charging FETs 30 which are connected to the battery module 2 in series, control the charging of the battery module 2, include the body diodes (31D and 32D), respectively, and are connected in series such that the respective body diodes (31D and 32D) are arranged in the same direction, and the control unit 6 which changes a conduction pattern in which the ON state and the OFF state of the at least two charging FETs 30 are switched and determines whether at least one of the at least two charging FETs 30 has an abnormality on the basis of a change in a measured voltage (for example, the voltage V1 or the voltage V2) provided, it is possible to accurately detect the abnormality of a charging cutoff function.

The battery control device 1 described above has a computer system therein. Then, a determination processing procedure of the battery control device 1 described above is stored in a computer readable recording medium in a form of a program, and the processing described above is performed by a computer reading and executing this program. Here, a computer readable recording medium refers to a magnetic disk, a magneto-optical disc, a CD-ROM, a DVD-ROM, a semiconductor memory, or the like. In addition, this computer program may be delivered to a computer via a communication line, and the computer which receives this delivery may execute the program.

While several embodiments of the present invention have been described, these embodiments have been presented by way of example and are not intended to limit the scope of the invention. These embodiments can be implemented in various other forms, and various omissions, replacements, and modifications can be made within a range not departing from the gist of the invention. These embodiments and modifications thereof are included in the invention described in the scope of claims, and the equivalent scope as well as included in the scope and gist of the invention.

### [Reference Signs List]

1 Battery control device
2 Battery module
4 Measurement switching unit
5 Voltage measurement unit
6 Control unit
7 Charging device
8 Charging switch
21 Battery cells
30, 31, 32 Charging FET
31D, 32D Body diode
41, 43 Switch
42, 44 Diode
51, 52, 53 Resistor
54 Amplifier
55 ADC
100 Battery unit

## Claims

1. A battery control device comprising:
at least two transistors being connected in series to a battery and being for controlling charging of the battery, each of the at least two transistors including a body diode, the at least two transistors being connected in series so that the body diodes are arranged in the same direction; and
a control unit configured to determine whether at least one of the at least two transistors is abnormal on the basis of a change of measured voltage caused by changing conduction patterns in which a conduction state and a non-conduction state of the at least two transistors are switched.

2. The battery control device according to claim 1,
wherein, when the change in the voltage is out of a predetermined range based on a forward voltage of the at least one transistor, the control unit determines the at least one transistor is abnormal.

3. The battery control device according to claim 1 or 2,
wherein the at least two transistors include a first transistor having a drain terminal connected to a first terminal of the battery and a second transistor having a drain terminal connected to a source terminal of the first transistor, and
the control unit is configured to determine whether the first transistor is abnormal on the basis of a change in a first voltage between a second terminal of the battery and the source terminal of the first transistor, and to determine whether the second transistor is abnormal on the basis of a change in a second voltage between the second terminal of the battery and a source terminal of the second transistor.

4. The battery control device according to claim 3,
wherein the control unit is configured to determine whether the battery is on charge on the basis of the change in the first voltage, and, the control unit is configured to determine, when the control unit determined that the battery is not on charge, whether the second transistor is abnormal on the basis of the change in the second voltage.

5. The battery control device according to claim 3 or 4,
wherein the control unit is configured to determine whether the first transistor is abnormal on the basis of a change between the first voltage measured in the conduction pattern in which the first transistor is in a conduction state and the second transistor is in a non-conduction state, and the first voltage measured in the conduction pattern in which both the first transistor and the second transistor are in the non-conduction state.

6. The battery control device according to any one of claims 3 to 5,
wherein the control unit is configured to determine whether the second transistor is abnormal on the basis of a change between the second voltage measured in the conduction pattern in which both the first transistor and the second transistor are in the conduction state, and the second voltage measured in the conduction pattern in which the first transistor is in the conduction state and the second transistor is in the non-conduction state.

7. The battery control device according to any one of claims 3 to 6,
wherein the control unit is configured to determine, when the control unit determined that the first transistor is normal on the basis of a change in the first voltage, whether the battery is in a float charging state on the basis of a change between the first voltage measured in the conduction pattern in which the first transistor is in the conduction state and the second transistor is in the non-conduction state, and the first voltage measured in the conduction pattern in which the first transistor is in the non-conduction state and the second transistor is in the conduction state.

8. An abnormality detection method which is performed by a battery control device, the battery control device comprising at least two transistors being connected in series to a battery and being for controlling charging of the battery, each of the at least two transistors including a body diode, the at least two transistors being connected in series so that the body diodes are arranged in the same direction, the method comprising:
a measurement step of measuring a voltage by changing conduction patterns in which a conduction state and a non-conduction state of the at least two transistors are switched; and
a determination step of determining whether at least one of the at least two transistors is abnormal on the basis of a change in the voltage measured in the measurement step.

9. A program which causes a computer of a battery control device comprising at least two transistors being connected in series to a battery and being for controlling charging of the battery, each of the at least two transistors including a body diode, the at least two transistors being connected in series so that the body diodes are arranged in the same direction, the program being to execute
a measurement step of measuring a voltage by changing conduction patterns in which a conduction state and a non-conduction state of the at least two transistors are switched; and
a determination step of determining whether at least one of the at least two transistors is abnormal on the basis of a change in the voltage measured in the measurement step.
